# EUROPEAN PATENT SPECIFICATION

(11) **EP 0 245 600 B1**
(45) Date of publication and mention of the grant of the patent: **09.06.1993**
(21) Application number: 87103053.2
(22) Date of filing: 04.03.1987
(51) Int. Cl.: C01B 6/06, C01B 25/00, C01G 15/00, H01L 31/02

(54) **Process for the plasma synthesis of hydride compounds and apparatus for carrying out said process**
Verfahren zur Herstellung mittels Plasma von Hydridverbindungen und Apparat für seine Durchführung
Procédé de préparation par plasma de composés de type hydrure et appareil pour mettre en oeuvre ce procédé

(30) Priority: 14.03.1986 US 839760
(43) Date of publication of application: 19.11.1987
(73) Proprietor: International Business Machines Corporation, Armonk, N.Y. 10504 (US)
(72) Inventor: Marinace, John Carter, Yorktown Heights, N.Y. 10 598 (US)
(74) Representative: Mönig, Anton, Dipl.-Ing.

(56) References cited:
- WO-A-86/03231
- US-A- 4 151 058
- US-A- 4 514 437
- PATENT ABSTRACTS OF JAPAN, vol. 10, no. 161 (C-352)(2217), 10 June 1986; & JP-A-61 14102 (MITSUSHITA DENKI SANGYO K.K.) 22.01.1986

## Description

The invention involves the formation of hydride compounds. Such compounds have at least two ingredients, one of which is hydrogen, and have as principal properties; a gaseous form with a capability that permits removal of the hydrogen in a later, minimum energy involvement reaction thereby leaving the remaining portion of the hydride compound for use in a further reaction. Hydride compounds generally in the art are formed by the reactions of metals and acids. The compounds, however, are generally highly toxic, and often explosive.

Recently, the use of hydride compounds of the elements employed in semiconductor technology has been found to be advantageous in connection with the chemical vapor deposition technology. In this technology, gases containing the various ingredients used in the semiconductor structure are caused to undergo a transformation, usually by decomposing, freeing thereby an ingredient in the vicinity of a semiconductor crystal so that the ingredient becomes part of the crystal structure.

In such applications, there are considerations of purity of the ingredients and handling problems involved with the highly toxic hydride compounds.

Background art is found for example in the following publications:
In the formation of Gallium Hydride (Ga₂H₆) in the "Chemistry of the Hydrides" text by Hurd, published by Wiley 1952, page 99, the use of a glow discharge is described to prepare the hydrogen for reaction.

In the formation of Arsenic Hydride (Arsine AsH₃) in the Mellor Inorganic Chemistry text, published by Wiley, page 837, nascent hydrogen H is described as the hydrogen reactant.

In U.S. Patent 4,151,058, in the hydrogenation of unsatisfied bonds in amorphous silicon semiconductor devices, the hydrogen (H₂) is converted to H.

In U.S. Patent 4,514,437, the use of an electromagnetic energy plasma is employed to vaporize ingredients to be deposited at a deposition site.
- FIG. 1: is a schematic illustration of an apparatus providing the parameters employed in the invention.
- FIG. 2: is an illustration of an apparatus for performing semiconductor chemical vapor deposition with "in situ" hydride formation.
- FIG. 3: is an illustration of an apparatus for forming a group III-group V intermetallic compound such as GaAs chemical vapor deposition with in situ hydride formation of the ingredients.
- FIG. 4: is a gas analysis mass-spectrum graph of arsenic hydride gases formed in accordance with the invention.
- FIG. 5: is a truncated gas analysis mass-spectrum graph of phosphorus hydride gases formed in accordance with the invention.

The invention is the formation of hydride compounds by reaction of gaseous hydrogen with the other hydride compound ingredients in either gaseous, solid or liquid form in a location having an externally impressed source of ionizing energy, the location being upstream of a vapor deposition site in a controlled environment deposition apparatus.

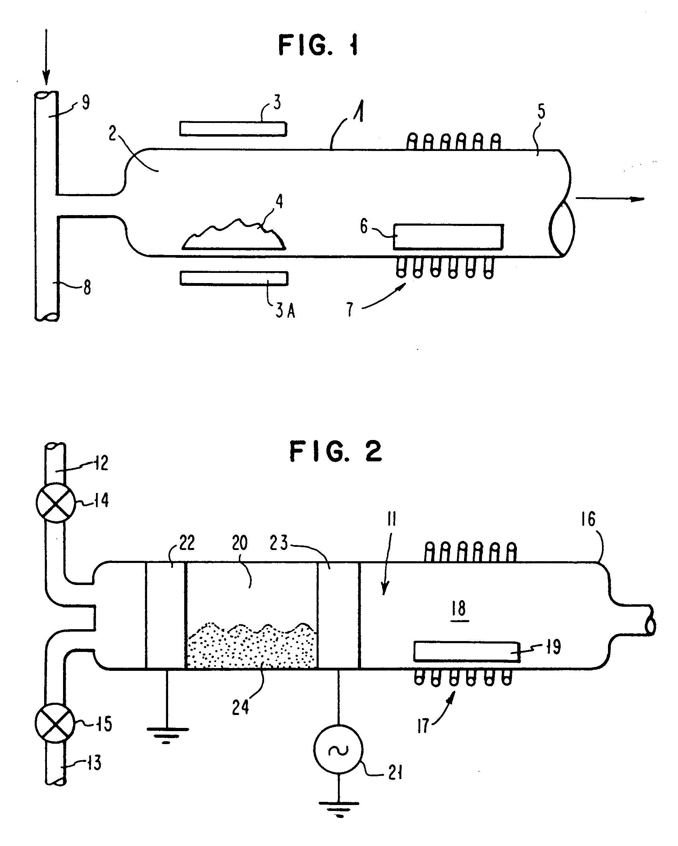

Referring to FIG. 1, a schematic apparatus is shown illustrating the parameters to be provided and controlled in accordance with the invention. In FIG. 1, a controlled environment container 1 is provided having a reaction site 2 in which is provided an ionizing energy, shown schematically as plates 3 and 3A. The energy preferably is impressed by an electromagnetic source, such as a Tesla type coil, not shown, connected appropriately between plates 3 and 3A.

Positioned at the site 2, within the ionizing energy is a quantity 4 of the ingredient other than hydrogen to be formed in the hydride compound. The site 2 is adjacent and upstream of a deposition site 5 at which the hydride compound is caused to decompose in the presence of a deposition substrate 6 such as a semiconductor crystal. In typical deposition apparatus, substrate temperature control means, such as a heater 7, is provided in the deposition site, the hydrogen ingredient is introduced through a separate port 8.

In accordance with the invention, the reaction of the hydride ingredients, in the presence of the ionizing energy not only converts the hydrogen H₂ into H⁺ but also provides a bombardment or sputtering effect both to the hydrogen and the other hydride ingredient 4 that operates to promote the reaction.

Further, in accordance with the invention, the reaction is found to be further enhanced through the introduction of an inert gas, such as argon, selected for atom or molecule size in bombardment, at another port in the system illustrated as 9. The presence of the inert gas provides more efficient hydride compound formation. The ingredient 4 may be provided in solid form, in liquid form or by local introduction through another port, not shown, in gaseous form.

The energy applied at the reaction site under the schematically illustrated elements 3 and 3A, should, at a minimum, be sufficient to ionize H₂ into H or nascent hydrogen. Higher levels of energy, however, will enhance the bombardment or sputtering aspect of the invention. In the presence of the energy, the hydrogen, an inert gas or the other ingredient itself is caused to engage in localized motion and collision which operates to remove oxides, exclude impurities, and promote reaction. This results in more efficient and purer hydride compound formation.

There are no stringent temperature requirements at the energy region 2 and room temperature is preferred.

While in the light of the description set forth, one skilled in the art will be able to apply the principles of the invention to many ingredients, for clarity, the following description will focus on the formation of the hydrides of the ingredients used with the semiconductor material GaAs including hydrides of As, P and Ga.

Referring next to FIG. 2, an illustrative apparatus is provided for the "in situ" generation and use of hydrides in a semiconductor application. In FIG. 2, a chemical vapor deposition type apparatus as used in semiconductor technology is shown. A reaction tube 11, such as quartz, is provided with a plurality of input ports 12 and 13 each controlled by a valve 14 and 15 respectively and with a gas output port 16. A heater 17, such as an electrical resistance type, is provided to control temperature at a deposition zone 18 wherein a substrate such as a Gallium Arsenide semiconductor monocrystal 19 is positioned.

The gaseous ingredients, hydrogen and an inert bombardment enhancing element such as argon, are introduced respectively at ports 12 and 13 under control of valves 14 and 15. Positioned upstream of the deposition region 18, an energy region 20 is provided wherein ionizing energy is applied. The ionizing energy is provided through a Tesla type coil and power supply well known in the art, shown schematically as element 21, connected across ground and the region 20 with contacts 22 and 23. The energy region 20 is maintained at room temperature. A quantity 24 of an ingredient for the hydride to be formed, such as solid As, is provided in the energy region 20.

In accordance with a further advantage of the invention, many impurities present in the ingredient positioned in the energy region do not form stable hydrides and thus when the hydride is formed, such impurities are eliminated resulting in a hydride gas product with greater purity than the ingredient sources. As an illustration, arsine formed in a plasma in accordance with the invention when decomposed, freeing the hydrogen, will be free of GeH₄ (Germane), a known impurity in commercially available Arsine.

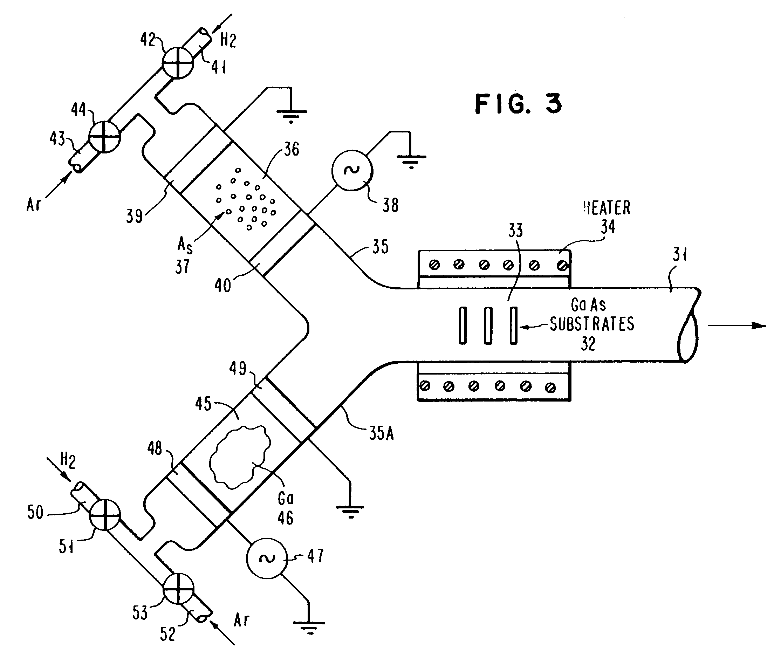

In accordance with the invention, the principles of forming a hydride by the reaction of hydrogen with the other ingredients of the hydride in the presence of an ionizing energy may be extended through the provision of a separate branch to the formation of intermetallic semiconductor compounds by the formation of hydrides of each of the ingredients in a branch of the apparatus adjacent to the location where the deposition is to take place. The arrangement is illustrated in connection with FIG. 3 wherein in a deposition section of the controlled environment container 31 substrates 32 are positioned in a deposition region 33, the temperature of which is controlled by heater 34.

Upstream of the deposition region 33, two branches 35 and 35A are shown, each for a separate ingredient of the intermetallic crystal to be grown in the deposition zone 33. In branch 35, there will be an ingredient region 36 with the quantity of ingredient 37 therein. For this illustration, assume it to be arsenic, and a source of external energy supplied for illustration purposes is a Tesla type coil and power supply, well known in the art, shown schematically as element 38 connected across ground and region 36 with contacts 39 and 40. Hydrogen is supplied to branch 35 through port 41 under control of valve 42 and similarly, argon is supplied through port 43 under control of valve 44.

A similar construction is employed in branch 35A wherein in an energy region 45, a quantity of the ingredient, for this illustration Gallium, 46 is provided. The source of energy is again provided through a Tesla type coil 47 connected to ground through contacts 48 and 49, and hydrogen is supplied through a port 50 under control of valve 51 and argon is supplied through a port 52 under control of a valve 53.

In the apparatus of FIG. 3, hydrides are formed in regions 36 and 45 of the respective ingredients in those regions and the hydrides are caused to decompose in the vicinity of the substrates, growing epitaxially a layer of a crystal made up of the two ingredients where, for purposes of illustration, the substrate is monocrystalline of gallium arsenide and as recited the ingredients are gallium and arsenic. Epitaxial layers of gallium arsenide will be formed.

The preferred mode of carrying out the invention involves the apparatus of FIG. 2.

In operation, the energy in region 20 converts H₂ into nascent hydrogen H and simultaneously imparts energy to the atoms and molecules of the gases and ingredients present in the energy region 20 thereby causing the efficient formation of a hydride of the ingredient 24 in high purity. The hydride is thus formed "in situ" in the container 11 where it moves downstream and is caused to decompose over the substrate 19 by the temperature at that point under control of the heater 17, resulting in crystal growth of, or impurity incorporation into, a layer on the substrate 19.

### EXAMPLE 1

In FIG. 2, the electrode spacing is not critical; an eleven centimeter (cm) spacing is employed. The plasma is not completely confined to the region 20 between the contacts 22 and 23. A Tesla coil 21, manufactured by Electrotechnic Products, models BD10AS or BD50, with a voltage applied at or near maximum, estimated at 50kV provides an output covering a broad frequency range, peaking at ∼ 400kHz with the power density in the plasma estimated to be about 1.0 W cm⁻³. The pressure, monitored by a bourdon gauge and a thermocouple gauge, not shown, is maintained over the range of 0.44 to 40 mbar (0.3 to 30 Torr) by means of a manual throttle valve, also not shown. The ingredient 24 is of gray As of stated 99.9999 % purity and in lump form with dimensions ranging from ∼ 0.5 to 1.5 cm. Any surface oxide is removed, at least partially, by heating to ∼ 200°C in a H₂ stream. The H₂ is maintained with a rated dewpoint of -70°C (∼1.0 ppm). The Ar is provided 99.999 % pure.

AsH₃ is formed under the following noncritical conditions:
H₂ flow rate = 200 ml min⁻¹
Ar flow rate = 25 ml min⁻¹
13.33 > Pressure > 2.67 mbar (10 > 2 Torr)
The gas sample that is produced under these conditions, when analyzed using a residual gas analyzer, provides the mass-spectrum shown in the graph of FIG. 3. The four gas species As⁺, AsH⁺, AsH₂⁺ and AsH₃⁺ have peak heights in good agreement with the published values of the cracking pattern for AsH₃ as published in "A Users Guide to Vacuum Technology", John F. O'Hanlon, John Wiley & Sons, New York, 1980, p. 385.

### EXAMPLE 2

Again employing the apparatus of FIG. 2, PH₃ is produced in a similar procedure to Example 1. An Ar flow rate of 50 ml min⁻¹ is employed. Therefore, the Ar fraction in the stream then varies from 12.5 % to 25 %. It is not critical in this range. At very high or very low values of Ar fraction, however, the yield could be markedly affected. The gas velocity through the reactor is estimated to be ∼58 cm sec⁻¹, based upon the tube cross-section, a 225 ml min⁻¹ input at a pressure of 13.33 mbar (10 Torr). This estimate neglects the volume of the P in the source 24. Such a high velocity minimizes the time that the reactive species can interact. The yield can be increased by increasing the residence time in the region of the solid source.

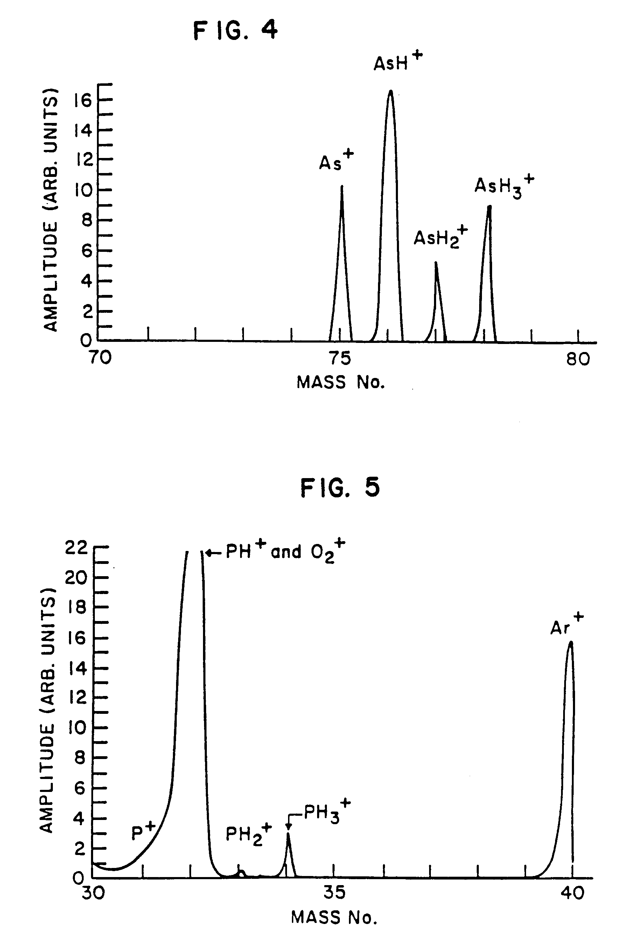

Referring to FIG. 5, gas samples produced under these conditions were analyzed using a residual-gas analyzer for the reaction products. FIG. 5 displays the mass-spectrometer spectrum of the PH₃, which also shows good agreement with published values of the cracking pattern for PH₃ as described in "A Users Guide to Vacuum Technology", John O'Hanlon, John Wiley & Sons, New York, 1980, p.385. The peak at mass number 32 is partly due to O₂⁺; other measurements show a peak at mass number 16, corresponding to O⁺. The presence of the O₂ is considered to be due to a leak in the equipment or due to inadequate purging prior to the synthesis. The concentration of PH₃ in the H₂ and Ar is estimated to be 1.0 to 1.5 %. It should be noted that the peak of the PH₃ trace in FIG. 5 has been truncated to the scale of FIG. 5 and in fact the peak is approximately double the scale.

What has been described is a technique and apparatus for the formation of hydride compounds wherein the compound ingredients and hydrogen are reacted together in the presence of energy at least sufficient to both ionize the hydrogen gas and simultaneously excite the compound ingredient.

## Claims

1. Method for the plasma synthesis of hydride compounds comprising:
combining gaseous hydrogen and a hydride ingredient other than hydrogen in a region within an enclosed container, said enclosed container being at a pressure of at least 0.44 mbar and below 40 mbar; and
applying externally impressed ionizing energy to said region to synthesize said gaseous hydride compound, said energy being at least sufficient to ionize hydrogen.

2. Method of claim 1 wherein said hydride ingredient other than hydrogen is As.

3. Method of claim 1 wherein said hydride ingredient other than hydrogen is P.

4. Apparatus for the plasma synthesis of hydride compounds comprising in combination:
a controlled environment vessel (1; 11; 31) having serially an input region (8, 9; 12, 13; 41, 43 and 50, 52), an energy region (2; 20; 36, 45) an output region and a deposition region (18; 33), said vessel being at a pressure of at least 0.44 mbar and below 40 mbar;
means (14, 15; 42, 44 and 51, 53) introducing gaseous hydrogen and an inert gas into said vessel at said input region;
at least one hydride ingredient other than hydrogen (4; 24; 37 and 46) for said hydride present in said energy region;
means (21; 38, 47) externally impressing energy at least in a quantity sufficient for ionization of said hydrogen in said energy region.

5. Apparatus of claim 4 wherein said externally energy impressing means is electromagnetic energy which is provided by a high frequency coil.

6. Apparatus of claim 4 wherein said output region is the entry port to a semiconductor chemical vapor deposition apparatus.

7. Apparatus of claim 6 including a separate hydride compound synthesis apparatus branch (35, 35A) for each of the hydride ingredient other than hydrogen to be introduced into said entry port of said semiconductor chemical vapor deposition apparatus.

8. Plasma semiconductor fabrication apparatus comprising:
a semiconductor formation site (33); at least one reaction site separate and upstream from said semiconductor formation site (33); said reaction site being at a pressure of at least 0.44 mbar and below 40 mbar;
means for providing at least one hydride ingredient other than hydrogen (37, 46) to each reaction site;
means (42; 51) for providing gaseous hydrogen to each reaction site;
means for subjecting said hydride ingredient other than hydrogen (37; 46) and said gaseous hydrogen to external energy sufficient to induce said hydride ingredient other than hydrogen and said hydrogen to form a gaseous hydride product at said reaction site; and
means for transporting said gaseous hydride product to said semiconductor formation site (33).

9. Apparatus of claim 8 including means providing an inert gas to said at least one reaction site.

10. Apparatus of claim 9 where said inert gas is Ar.

11. Apparatus of claim 8 where said hydride ingredient other than hydrogen (37, 46) is selected from As and P.

12. Apparatus of claim 11 where said hydride ingredient other than hydrogen is at least one of As and P and a second ingredient is Ga.

## Patentansprüche

1. Verfahren zur Synthese von Hydridverbindungen mittels Plasma, welches umfaßt:
Zusammenbringen von gasförmigem Wasserstoff und einem Hydridbestandteil, der nicht Wasserstoff ist, in einem Bereich innerhalb eines abgeschlossenen Gefäßes, wobei sich dieses Gefäß unter einem Druck von mindestens 0,44 mbar und unter 40 mbar befindet, und
Anwenden von extern angelegter Ionisierungsenergie auf diesen Bereich, um die gasförmige Hydridverbindung zu synthetisieren, wobei diese Energie mindestens ausreichen muß, um Wasserstoff zu ionisieren.

2. Verfahren nach Anspruch 1, wobei As der Hydridbestandteil ist.

3. Verfahren nach Anspruch 2, wobei P der Hydridbestandteil ist.

4. Apparat zur Synthese von Hydridverbindungen mittels Plasma, der die folgende Kombination umfaßt:
ein Gefäß mit kontrolliertem Milieu (1; 11; 31), das hintereinander einen Eingangsbereich (8, 9; 12, 13; 41, 43 und 50, 52), einen Energiebereich (2; 20; 36, 45), einen Ausgangsbereich und einen Abscheidungsbereich (18; 33) besitzt, wobei sich das Gefäß unter einem Druck von mindestens 0,44 mbar und unter 40 mbar befindet;
Mittel (14, 15; 42, 44 und 51, 53) zum Einführen des gasförmigen Wasserstoffs und eines Inertgases in das Gefäß am Eingangsbereich;
mindestens einen Hydridbestandteil (4; 24; 37 und 46) für das Hydrid, welcher nicht Wasserstoff ist, der in dem Energiebereich anwesend ist;
Mittel (21; 38, 47) zum externen Anlegen von mindestens einer Energiemenge, die zur Ionisierung des Wasserstoffs im Energiebereich ausreicht.

5. Apparat nach Anspruch 4, bei dem das externe Energieanlegungsmittel elektromagnetische Energie ist, die durch eine Hochfrequenzspule geliefert wird.

6. Apparat nach Anspruch 4, bei dem der Ausgangsbereich der Eingangsanschluß zu einer Halbleiter-CVD-Vorrichtung ist.

7. Apparat nach Anspruch 6 mit einem separaten Zweig des Hydridverbindungssyntheseapparats (35, 35A) für jeden Hydridbestandteil, der nicht Wasserstoff ist, welcher in den Eingangsanschluß der Halbleiter-CVD-Vorrichtung einzuführen ist.

8. Plasma-Halbleiterherstellungsapparat, welcher umfaßt:
eine Halbleiterbildungsstelle (33), mindestens eine Reaktionsstelle separat und oberhalb der Halbleiterbildungsstelle (33), wobei sich die Reaktionsstelle unter einem Druck von mindestens 0,44 mbar und unter 40 mbar befindet;
Mittel zur Bereitstellung von mindestens einem Hydridbestandteil (37, 46), der nicht Wasserstoff ist, an jede Reaktionsstelle;
Mittel (42; 51) zur Bereitstellung von gasförmigem Wasserstoff an jede Reaktionsstelle;
Mittel, um den Hydridbestandteil (37; 46), der nicht Wasserstoff ist, und den gasförmigen Wasserstoff der externen Energie zu unterwerfen, die ausreichen soll, um den Hydridbestandteil, der nicht Wasserstoff ist, und den Wasserstoff anzuregen, an der Reaktionsstelle ein gasförmiges Hydridprodukt zu bilden, und
Mittel, um das gasförmige Hydridprodukt zu der Halbleiterbildungsstelle (33) zu transportieren.

9. Apparat nach Anspruch 8 einschließlich Mittel zur Bereitstellung eines Inertgases an mindestens eine Reaktionsstelle.

10. Apparat nach Anspruch 9, bei dem Ar das Inertgas ist.

11. Apparat nach Anspruch 8, bei dem der Hydridbestandteil (37, 46), der nicht Wasserstoff ist, aus As und P ausgewählt wird.

12. Apparat nach Anspruch 11, bei dem der Hydridbestandteil, der nicht Wasserstoff ist, mindestens einer von As und P ist, und Ga ein zweiter Bestandteil ist.

## Revendications

1. Procédé pour la synthèse par plasma de composés de type hydrure, comprenant:
la combinaison d'hydrogène gazeux et d'un composant de type hydrure autre que l'hydrogène dans une région située à l'intérieur d'un récipient fermé, ce récipient fermé à une pression d'au moins 0,44 mbar et inférieure à 40 mbar; et
l'application d'énergie ionisante fournie extérieurement à cette région pour synthétiser ce composé gazeux de type hydrure, cette énergie étant au moins suffisante pour ioniser l'hydrogène.

2. Procédé suivant la revendication 1, dans lequel ce composant de type hydrure autre que l'hydrogène est As.

3. Procédé suivant la revendication 1, dans lequel ce composant de type hydrure autre que l'hydrogène est P.

4. Appareil pour la synthèse par plasma de composés de type hydrure, comprenant en association:
un récipient à environnement contrôlé (1; 11; 31) ayant en série une région d'entrée (8, 9; 12, 13; 41, 43 et 50, 52), une région d'énergie (2; 20; 36; 45), une région de sortie et une région de dépôt (18; 33), ce récipient étant à une pression d'au moins 0,44 mbar et inférieure à 40 mbar;
des moyens (14, 15; 42, 44 et 51, 53) introduisant de l'hydrogène gazeux et un gaz inerte dans ce récipient au niveau de la région d'entrée;
au moins un composé de type hydrure autre que l'hydrogène (4; 24; 37 et 46) pour cet hydrure présent dans cette région d'énergie;
des moyens (21; 38; 47) fournissant depuis l'extérieur de l'énergie en une quantité au moins suffisante pour ioniser cet hydrogène dans cette région d'énergie.

5. Appareil suivant la revendication 4, dans lequel ces moyens fournissant l'énergie depuis l'extérieur comprennent une source d'énergie électromagnétique qui provient d'un serpentin haute fréquence.

6. Appareil suivant la revendication 4, dans lequel cette région de sortir est l'orifice d'entrée d'un appareil de dépôt de vapeur chimique pour semiconducteur.

7. Appareil suivant la revendication 6, comprenant un bras distinct d'appareil de synthèse du composé de type hydrure (35, 35A) pour chacun des composants de type hydrure autre que l'hydrogène devant être introduits dans cet orifice d'entrée de cet appareil de dépôt de vapeur chimique pour semiconducteur.

8. Appareil de fabrication de semiconducteur par plasma comprenant:
un site de formation de semiconducteur (33); au moins un site de réaction séparé et en amont de ce site de formation de semiconducteur (33); ce site de réaction étant à une pression d'au moins 0,44 mbar et inférieure à 40 mbar;
des moyens pour fournir au moins un composant de type hydrure autre que l'hydrogène (37, 46) à chaque site de réaction;
des moyens (42; 51) pour fournir de l'hydrogène gazeux à chaque site de réaction;
des moyens pour soumettre ce composant de type hydrure autre que l'hydrogène (37; 46) et cet hydrogène gazeux à une énergie externe suffisante pour induire la formation par ce composant de type hydrure autre que l'hydrogène et cet hydrogène, d'un produit gazeux de type hydrure à ce site de réaction; et
des moyens pour transporter ce produit gazeux de type hydrure jusqu'au site de formation du semiconducteur (33).

9. Appareil suivant la revendication 8, comprenant des moyens pour fournir un gaz inerte à ce site de réaction au moins présent.

10. Appareil suivant la revendication 9, dans lequel ce gaz inerte est l'argon.

11. Appareil suivant la revendication 8, dans lequel ce composant de type hydrure autre que l'hydrogène (37, 46) est choisi parmi As et P.

12. Appareil suivant la revendication 11, dans lequel ce composant de type hydrure autre que l'hydrogène est au moins l'un des As et P et un second composant est Ga;
